(19) Europäisches Patentamt
European Patent Office
Office européen des brevets

(11) EP 4 095 175 A1

(12) EUROPEAN PATENT APPLICATION
published in accordance with Art. 153(4) EPC

(43) Date of publication:
30.11.2022 Bulletin 2022/48

(21) Application number: 22737700.9

(22) Date of filing: 28.01.2022

(51) International Patent Classification (IPC):
*C08G 18/36* (2006.01) *C08G 18/08* (2006.01)
*C08K 9/06* (2006.01) *C08L 75/04* (2006.01)
*H01L 23/373* (2006.01)

(86) International application number:
PCT/JP2022/003250

(87) International publication number:
WO 2022/215326 (13.10.2022 Gazette 2022/41)

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME
Designated Validation States:
KH MA MD TN

(30) Priority: 08.04.2021 JP 2021066035

(71) Applicant: Showa Denko K.K.
Tokyo 105-8518 (JP)

(72) Inventors:
- FUNAHASHI, Hajime
Kanagawa 2218517 (JP)
- MINORIKAWA, Naoki
Kanagawa 2218517 (JP)
- SATOH, Hikaru
Kanagawa 2218517 (JP)
- KOBAYASHI, Ikue
Kanagawa 2218517 (JP)
- YUKUTAKE, Hajime
Kanagawa 2218517 (JP)
- IEMURA, Takeshi
Kanagawa 2218517 (JP)

(74) Representative: Strehl Schübel-Hopf & Partner
Maximilianstrasse 54
80538 München (DE)

# (54) HEAT CONDUCTIVE URETHANE RESIN COMPOSITION AND CURED PRODUCT

(57) A thermally conductive urethane resin composition comprising a castor oil-based polyol, a polyisocyanate compound, and a filler, wherein
an equivalent ratio [NCO/OH] of isocyanato groups of the polyisocyanate compound to hydroxyl groups of the castor oil-based polyol is from 0.8 to 1.6,
the filler comprises a filler (A) having an average particle diameter of 0.03 to 10 μm, and
the filler (A) has been surface-treated with a specific surface treatment agent.

EP 4 095 175 A1

## Description

Technical Field

The present invention relates to a thermally conductive urethane resin composition and a cured product of the thermally conductive urethane resin composition.

Background Art

Removal of heat from heat generating bodies has been an issue in various fields. Removal of heat particularly from heat generating electronic components such as electronic devices, personal computers, and engine control units (ECUs) for automobiles, and batteries has been an important issue. The amounts of heat generated from heat generating components have increased recently, and thus heat dissipation materials having a high thermal conductivity have been used as a measure against heat.

Materials called potting materials, which have a thermal conductivity enhanced by adding a filler to a silicone material, have been used as casting materials because of their heat resistance and availability. Since the potting materials are liquid, they can be poured, applied, or the like, and enable works to be automated easily, and thus have been prevalently used. However, silicone materials comprise low-molecular siloxane. The siloxane is vaporized to cause a conductive failure or the like, and thus use thereof is often discouraged. For this reason, casting materials having a high thermal conductivity other than silicone materials are required, and ones additionally having a low hardness have been required in order to protect electronic components from vibration.

Examples of alternative materials for silicone materials include urethane materials. However, polyol used in urethane has a high viscosity, inhibiting high filling with a thermally conductive filler. Isocyanate used as a curing agent, which has low chemical stability, may react with the surface treatment agent for a thermally conductive filler, may react with a dispersant, or may react directly with the thermally conductive filler. Accordingly, low-hardness and highly thermally conductive urethane compositions have been difficult to produce.

Various approaches have been suggested conventionally in order to resolve these issues. For example, PTL 1 discloses a polyurethane resin composition that comprises a castor oil-based polyol as a hydroxyl group-containing compound, polymethylene polyphenyl polyisocyanate as an isocyanate group-containing compound, and aluminum hydroxide as an inorganic filler. PTL 2 discloses a polyurethane resin composition that comprises a hydroxyl group-containing compound containing polybutadiene polyol and a castor oil-based polyol, an isocyanate group-containing compound containing an isocyanurate-modified product of a polyisocyanate compound and an allophanate-modified product of a polyisocyanate compound, and an inorganic filler.

PTL 3 discloses a composition that comprises a reactive organic matrix comprising at least one of epoxy, acrylate, urethane, or silicone, a first thermally conductive filler having a specific average particle diameter and thermal conductivity, and a second thermally conductive filler. Further, PTL 4 discloses a thermally conductive polyurethane potting adhesive that comprises a first component comprising polyether polyol, a small molecule chain extender, a flame retardant, a thermally conductive filler, an inorganic filler, a wetting dispersant, a color paste, an organosilicon coupling agent, and a catalyst in a specific amount, and a second component comprising polymethylene polyisocyanate and carbodiimide-modified diphenylmethane diisocyanate.

Citation List

Patent Literature

PTL 1: JP-A-2019-1887
PTL 2: JP-A-2015-89909
PTL 3: WO 2020/077031
PTL 4: CN-A-111607351

Summary of Invention

Technical Problem

However, in PTLs 1 to 4, any of cured products of the polyurethane resin compositions described therein does not have a sufficient thermal conductivity, and hydrolytic resistance, which is a feature of urethane including a castor

oil-based polyol, has not been examined. Moreover, the polyurethane resin composition described in PTL 2 has a low consistency, which leads to an increase in the hardness of cured products.

The present invention has been made in view of these circumstances, and it is an object thereof to provide a thermally conductive urethane resin composition that can lower hardness while maintaining a high thermal conductivity and can give a cured product excellent in hydrolytic resistance.

Solution to Problem

The present inventors have made intensive studies to solve the problems and have found that the problems can be solved by the following invention.

That is, the present disclosure relates to the following.

[1] A thermally conductive urethane resin composition comprising a castor oil-based polyol, a polyisocyanate compound, and a filler, wherein

an equivalent ratio [NCO/OH] of isocyanato groups of the polyisocyanate compound to hydroxyl groups of the castor oil-based polyol is from 0.8 to 1.6,
the filler comprises a filler (A) having an average particle diameter of 0.03 to 10 μm, and
the filler (A) has been surface-treated with a polymer-type surface treatment agent derived from an alkoxysilane and having a viscosity at 25°C of 10 to 500 mPa·s.

[2] The thermally conductive urethane resin composition according to the above [1], wherein the polymer-type surface treatment agent is a compound represented by the following general formula (I):

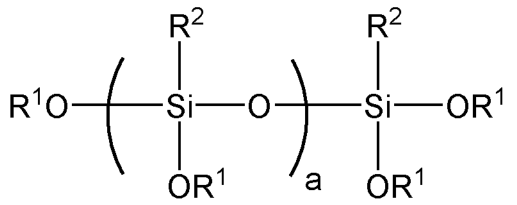
(I)

wherein $R^1$ and $R^2$ are each independently an unsubstituted or substituted alkyl group, a plurality of $R^1$ and a plurality of $R^2$ are each optionally identical or different, and a is an integer of 1 to 30.
[3] The thermally conductive urethane resin composition according to the above [1] or [2], wherein the filler further comprises a filler (B) having an average particle diameter of more than 10 μm and 300 μm or less.
[4] The thermally conductive urethane resin composition according to the above [3], further comprising a dispersant.
[5] The thermally conductive urethane resin composition according to the above [3] or [4], wherein the filler (B) is aluminum nitride having a silicon-containing oxide coating on the surface thereof.
[6] The thermally conductive urethane resin composition according to any of the above [1] to [5], wherein a content of the filler (A) that has been surface-treated with the polymer-type surface treatment agent is from 1 to 1000 parts by mass based on 100 parts by mass in total of the castor oil-based polyol and the polyisocyanate compound.
[7] The thermally conductive urethane resin composition according to any of the above [3] to [5], wherein a content of the filler (B) is from 300 to 3000 parts by mass based on 100 parts by mass in total of the castor oil-based polyol and the polyisocyanate compound.
[8] The thermally conductive urethane resin composition according to any of the above [1] to [7], wherein the polyisocyanate compound is at least one selected from the group consisting of polymethylene polyphenyl polyisocyanates, carbodiimide-modified diphenylmethane diisocyanates, castor oil-modified diphenylmethane diisocyanates, and allophanate-modified polyisocyanates.
[9] The thermally conductive urethane resin composition according to the above [4], wherein the surface treatment agent does not interact with the dispersant.
[10] The thermally conductive urethane resin composition according to any of the above [1] to [9], having a consistency at 23°C of 290 to 400.
[11] A cured product of the thermally conductive urethane resin composition according to any of the above [1] to [10].
[12] The cured product of the thermally conductive urethane resin composition according to the above [11], having a thermal conductivity of 3.0 W/m·K or more.
[13] The cured product of the thermally conductive urethane resin composition according to the above [11] or [12], having a Shore 00 hardness measured in accordance with ASTM D2240 of 20 to 97.

[14] A heat dissipation sheet comprising the cured product of the thermally conductive urethane resin composition according to any of the above [11] to [13].

[15] An electronic component comprising the cured product of the thermally conductive urethane resin composition according to any of the above [11] to [13].

Advantageous Effects of Invention

According to the present invention, it is possible to provide a thermally conductive urethane resin composition that can lower hardness while maintaining a high thermal conductivity and can give a cured product excellent in hydrolytic resistance.

Description of Embodiments

Hereinbelow, the present invention will be described in detail with reference to one embodiment.

The term "castor-oil based" herein means natural oils and fats and processed natural oils and fats comprising a triester compound of ricinoleic acid and glycerin, or synthetic oils and fats comprising a triester compound obtained by synthesis. The term "castor oil-based polyol" means an ester compound of ricinoleic acid and/or hydrogenated ricinoleic acid and polyhydric alcohol. The ester compound may be a compound modified using castor oil obtained by pressing seeds of castor (castor bean, academic name: Ricinus communis L.) or a derivative thereof as a starting material, or may be a polyol obtained by using a raw material other than castor oil as a starting material.

The term "consistency" herein is an index indicating the flexibility of a urethane resin composition. A larger consistency value indicates a softer urethane resin composition. The consistency can be measured by a method in accordance with JIS K2220:2013.

<Thermally conductive urethane resin composition>

A thermally conductive urethane resin composition of the present embodiment (hereinbelow, also simply referred to as the urethane resin composition) is a thermally conductive urethane resin composition comprising a castor oil-based polyol, a polyisocyanate compound, and a filler, wherein

the equivalent ratio [NCO/OH] of isocyanato groups of the polyisocyanate compound to hydroxyl groups of the castor oil-based polyol is from 0.8 to 1.6,

the filler comprises (A) a filler having an average particle diameter of 0.03 to 10 μm, and

the filler (A) has been surface-treated with a polymer-type surface treatment agent derived from an alkoxysilane and having a viscosity at 25°C of 10 to 500 mPa·s (hereinbelow, simply referred to as the "polymer-type surface treatment agent").

[Castor oil-based polyol]

The castor oil-based polyol used in the present embodiment is an ester compound of ricinoleic acid and/or hydrogenated ricinoleic acid and a polyhydric alcohol. The polyol may be a polyol obtained using castor oil as a starting material or may be a polyol obtained using a raw material other than castor oil, as a starting material as long as the polyol has this configuration. The polyhydric alcohol is not particularly limited.

The number of hydroxyl groups of the castor oil-based polyol is preferably more than 1 and 3 or less, more preferably 2 or more and 3 or less, from the viewpoint of reduction in the number of crosslink points.

The term "number of hydroxyl groups" herein means an average number of hydroxyl groups contained in one molecule of the castor oil-based polyol and may take a value after the decimal point such as 1.5.

The hydroxyl value of the castor oil-based polyol is preferably from 10 to 200 mgKOH/g, more preferably from 15 to 170 mgKOH/g, further preferably from 15 to 120 mgKOH/g, still further preferably from 15 to 80 mgKOH/g, still further preferably 15 to 50 mgKOH/g, from the viewpoint of curability.

The acid value of the castor oil-based polyol is preferably from 0.2 to 5.0 mgKOH/g, more preferably from 0.2 to 3.8 mgKOH/g, from the viewpoint of water resistance and heat resistance.

The hydroxyl value and acid value are values measured in accordance with JIS K0070:1992.

The viscosity at 25°C of the castor oil-based polyol is preferably from 20 to 300 mPa·s, more preferably from 30 to 250 mPa·s, further preferably from 50 to 200 mPa·s, still further preferably 50 to 100 mPa·s. When the viscosity is within the range, the amount of the filler to be filled can be increased while the physical properties of the castor oil-based polyol are maintained, and the viscosity of the urethane resin composition can be lowered.

The viscosity is a value measured at 25°C based on JIS Z8803:2011 "Methods for viscosity measurement of

liquid" using a rotary viscometer.

Examples of the castor oil-based polyol include polyols produced using castor oil, castor oil fatty acid, hydrogenated castor oil obtained by hydrogenation of castor oil, or hydrogenated castor oil fatty acid obtained by hydrogenation of castor oil fatty acid. Examples thereof further include transesterified products of castor oil and other natural fats and oils, reaction products of castor oil and polyhydric alcohol, esterification reaction products of castor oil fatty acid and polyhydric alcohol, hydrogenated castor oil, transesterified products of hydrogenated castor oil and other natural fats and oils, reaction products of hydrogenated castor oil and polyhydric alcohol, esterification reaction products of hydrogenated castor oil fatty acid and polyhydric alcohol, and polyols having alkylene oxide addition-polymerized thereto. These may be used singly or in admixture of two or more.

The castor oil-based polyol can be produced in accordance with a known production method.

The content of the castor oil-based polyol used in the present embodiment is preferably from 2.0 to 10.0% by mass, more preferably from 2.5 to 9.0% by mass, further preferably from 3.0 to 8.0% by mass based on the total amount of the urethane resin composition. When the content of the castor oil-based polyol is within the range, the urethane resin composition can be cured, and the cured product can have a hardness within a desired range.

The urethane resin composition of the present embodiment may contain a polyol other than the castor oil-based polyol. Examples of the polyol other than the castor oil-based polyol include polyester polyols and polyether polyols.

When the polyol used in the present embodiment contains a polyol other than the castor oil-based polyol, the content thereof is preferably 2.0% by mass or less, more preferably 1.5% by mass or less, further preferably 1.0% by mass based on the total amount of the polyol. When the content of the polyol other than the castor oil-based polyol is 2.0% by mass or less, the consistency of the urethane resin composition can be within a desired range, and additionally, the hydrolytic resistance of a cured product of the urethane resin composition can be made favorable.

[Polyisocyanate compound]

The polyisocyanate compound used in the present embodiment is a compound having 2 or more isocyanato groups in one molecule. Examples thereof include aromatic polyisocyanates, aliphatic polyisocyanates, and alicyclic polyisocyanates. These may be used singly or in admixture of two or more.

Examples of the aromatic polyisocyanate include phenylene diisocyanate, 2,4-tolylene diisocyanate, 2,6-tolylene diisocyanate, 2,2'-diphenylmethane diisocyanate, 4,4'-diphenylmethane diisocyanate, 4,4'-toluidine diisocyanate, 4,4'-diphenyl ether diisocyanate, 4,4'-diphenyl diisocyanate, 1,5-naphthalene diisocyanate, and xylylene diisocyanate.

Examples of the aliphatic polyisocyanate include trimethylene diisocyanate, tetramethylene diisocyanate, hexamethylene diisocyanate, pentamethylene diisocyanate, 1,2-propylene diisocyanate, 1,3-butylene diisocyanate, dodecamethylene diisocyanate, and 2,4,4-trimethyl hexamethylene diisocyanate.

Examples of the alicyclic polyisocyanate include 1,3-cyclopentene diisocyanate, 1,3-cyclohexane diisocyanate, 1,4-cyclohexane diisocyanate, isophorone diisocyanate, hydrogenated diphenylmethane diisocyanate, hydrogenated xylylene diisocyanate, hydrogenated tolylene diisocyanate, and hydrogenated tetramethyl xylylene diisocyanate.

Additional examples include carbodiimide-modified polyisocyanates, castor oil-modified polyisocyanates, biuret-modified polyisocyanates, allophanate-modified polyisocyanates, polymethylene polyphenyl polyisocyanates (polymeric MDIs), and isocyanurate-modified polyisocyanates of the aromatic polyisocyanates, aliphatic polyisocyanates, and alicyclic polyisocyanates.

Of these, preferable is a at least one selected from the group consisting of polymethylene polyphenyl polyisocyanates (polymeric MDIs), carbodiimide-modified diphenylmethane diisocyanates, castor oil-modified diphenylmethane diisocyanates, and allophanate-modified polyisocyanates, from the viewpoint of lowering hardness of a cured product of the urethane resin composition and safety of the polyisocyanate compound per se.

The equivalent ratio [NCO/OH] of isocyanato groups of the polyisocyanate compound to hydroxyl groups of the castor oil-based polyol is from 0.8 to 1.6. When the equivalent ratio [NCO/OH] is 0.8 or more, the hydrolytic resistance of a cured product of the urethane resin composition can be enhanced, and when the equivalent ratio [NCO/OH] is 1.6 or less, the hardness of the cured product of the urethane resin composition can be lowered. From the viewpoint described above, the equivalent ratio [NCO/OH] is preferably from 0.8 to 1.5, more preferably from 1.0 to 1.3.

The content of the polyisocyanate compound is preferably from 0.30 to 1.30% by mass, more preferably from 0.35 to 1.25% by mass, further preferably from 0.40 to 1.20% by mass based on the total amount of the urethane resin composition. When the content of the polyisocyanate compound is within the range, the urethane resin composition can be cured, and the cured product can have a hardness within a desired range.

[Filler (A)]

The filler used in the present embodiment comprises a filler that has an average particle diameter of 0.03 to

10 μm, the filler having been obtained by surface-treating a filler before surface treatment mentioned below (denoted as the "filler (A)") with a polymer-type surface treatment agent.

The "average particle diameter" herein is a volume average particle diameter, can be determined from the particle diameter at an integrated volume of 50% (50% particle diameter: D50) in the particle size distribution measured using a laser diffraction-type particle size analyzer (for example, manufactured by MicrotracBEL Corp., trade name: MT3300EXII), and specifically can be measured by the method described in examples.

The filler (A) preferably has a thermal conductivity of 1 W/m·K or more from the viewpoint of imparting thermally conductive properties.

Examples of the filler (A) include oxides, nitrides, carbides, and hydroxides of metals, silicone, or boron. Examples of the oxides include zinc oxide, aluminum oxide, magnesium oxide, silica, and quartz powder, and examples of the nitrides include aluminum nitride, boron nitride, and silicon nitride. Examples of the carbides include silicon carbide and boron carbide, and examples of the hydroxides include aluminum hydroxide, magnesium hydroxide, and iron hydroxide. These may be used singly or in admixture of two or more.

In consideration of the balance between thermal conductivity and costs, aluminum oxide (alumina) is preferable, and particularly, α-alumina has a high thermally conductive property and is preferable. From the viewpoint of highly thermally conductive properties, aluminum nitride and boron nitride are preferable used, and from the viewpoint of low costs, silica, quartz powder, and aluminum hydroxide are preferably used. Particularly, aluminum hydroxide can exhibit thermally conductive properties beyond expectations by a combination of different particle diameters or combined use with alumina, and furthermore can impart flame retardance because of being a hydroxide, and thus, aluminum hydroxide is a useful filler.

The shape of the filler (A) is not particularly limited as long as being particulate, and examples thereof include true-spherical, spherical, rounded, scaly, and crushed. These may be used in combination.

The specific surface area of the filler (A), as determined by the BET method, is preferably from 0.05 to 10.0 $m^2/g$, more preferably from 0.06 to 9.0 $m^2/g$, further preferably from 0.06 to 8.0 $m^2/g$. When the specific surface area is 0.05 $m^2/g$ or more, high filling with filler is enabled, and the thermally conductive properties can be enhanced. When the specific surface area is 10.0 $m^2/g$ or less, the urethane resin composition becomes to be integrated well.

The specific surface area of the filler (A) can be measured using a specific surface area measurement apparatus by the single point BET method based on nitrogen adsorption, and specifically can be measured by the method described in examples.

The filler (A) may be a combination of a plurality of fillers as long as fillers (A) having a different particle size distribution each have the average particle diameter, from the viewpoint of thermally conductive properties. For example, the filler (A) may be a combination of a filler having an average particle diameter of 0.03 μm or more and less than 0.8 μm as a filler (A1) and a filler having an average particle diameter of 0.8 μm or more and 10 μm or less as a filler (A2).

The average particle diameter of the filler (A1) is preferably 0.04 μm or more and less than 0.8 μm, more preferably 0.1 μm or more and 0.7 μm or less.

The average particle diameter of the filler (A2) is preferably 0.9 μm or more and 10 μm or less, more preferably 1.0 μm or more and 10 μm or less.

The filler (A1) and the filler (A2) may be fillers of different types. Specific examples thereof include a combination of alumina as the filler (A1) and aluminum nitride as the filler (A2) and a combination of alumina as the filler (A1) and boron nitride as the filler (A2).

The polymer-type surface treatment agent used for surface treatment of the filler (A) has its viscosity at 25°C of 10 to 500 mPa·s. When the viscosity is 10 mPa·s or more, the surface treatment agent can be determined to have been sufficiently polymerized. Use of such a polymer-type surface treatment agent enables the surface of the filler (A) to be sufficiently coated and hydrolytic resistance of a cured product to be obtained of the urethane resin composition to be excellent. When the viscosity is 500 mPa·s or less, the urethane resin composition can have a larger consistency or a lower viscosity. From such a viewpoint, the viscosity at 25°C of the polymer-type surface treatment agent is preferably from 15 to 400 mPa·s, more preferably from 20 to 300 mPa·s, further preferably from 25 to 100 mPa·s, still further preferably from 30 to 50 mPa·s, still further preferably from 30 to 40 mPa·s.

The viscosity is a value measured at 25°C based on JIS Z8803:2011 "Methods for viscosity measurement of liquid" using a rotary viscometer, and specifically can be measured by the method described in examples.

The specific gravity at 25°C of the polymer-type surface treatment agent is preferably from 0.95 to 1.08, more preferably from 0.98 to 1.06, from the viewpoint of hydrolytic resistance.

The polymer-type surface treatment agent is not particularly limited as long as being derived from an alkoxysilane and having a viscosity at 25°C within the range. However, from the viewpoint of hydrolytic resistance, the surface treatment agent is preferably a compound represented by the following general formula (I). The compound represented by the following general formula (I) is a dimer or higher polymer (hydrolytic polycondensation product) obtained by condensation of some of alkoxy groups of an alkoxysilane that can be represented by $R^2_{3-x}Si(OR^1)_x$, wherein x = 2 or 3.

The polymer-type surface treatment agent may be used singly or in admixture of two or more.

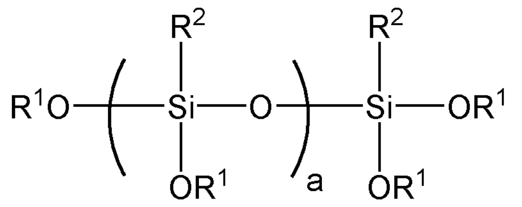

(I)

Wherein $R^1$ and $R^2$ are each independently an unsubstituted or substituted alkyl group. When a plurality of $R^1$ and $R^2$ are present, the plurality of $R^1$ and $R^2$ are each optionally identical or different, and a is an integer of 1 to 30.

The alkyl groups of the $R^1$ and $R^2$ are optionally unsubstituted or substituted.

The alkyl group of the $R^1$ is preferably an alkyl group having 1 to 6 carbon atoms, more preferably an alkyl group having 1 to 3 carbon atoms. The alkyl group of the $R^2$ is preferably an alkyl group having 1 to 12 carbon atoms, more preferably an alkyl group having 1 to 6 carbon atoms, further preferably an alkyl group having 1 to 3 carbon atoms.

Examples of the alkyl groups of the $R^1$ and $R^2$ include a methyl group, an ethyl group, a n-propyl group, an isopropyl group, a n-butyl group, an isobutyl group, a tert-butyl group, a pentyl group, a hexyl group, an octyl group, and a decyl group. Of these, a methyl group, an ethyl group, a n-propyl group, and an isopropyl group are preferable.

Examples of a substituent that may be possessed by the alkyl group include a halogen atom, an epoxy group, an isocyanato group, a hydroxyl group, an amino group, a carboxy group, an acyl group, and alkoxy group. These substituents may be of one kind or of two or more kinds.

The a is an integer of 1 to 30, and from the viewpoint of hydrolyzability of the alkoxy group, preferably an integer of 1 to 25, more preferably an integer of 2 to 20, further preferably an integer of 5 to 15, still further preferably an integer of 8 to 12.

The polymer-type surface treatment agent may be partially branched.

The polymer-type surface treatment agent preferably does not interact with a dispersant and a reaction accelerator mentioned below, from the viewpoint of preservability. Here, the phrase "does not interact with" herein means that the polymer-type surface treatment agent does not react with a dispersant and a reaction accelerator to be polymerized, the viscosity of the composition excluding the polyisocyanate compound (generally referred to as an A material) does not increase, and the preservability is not compromised. The fact that the polymer-type surface treatment agent does not interact with the dispersant and reaction accelerator can be confirmed with absence of an increase in the initial consistency of the A material comprising these over time.

Examples of commercially available products of the polymer-type surface treatment agent include "Dynasylan (R) SIVO408" and "Dynasylan (R) 9896" manufactured by Evonik Industries AG, wherein $R^1$ is an ethyl group in the general formula (I).

Examples of a surface treatment method include a dry method, a wet method, and an integral blend method, and any of the methods may be used. The dry method is a method in which a predetermined amount of the surface treatment agent, as is or in a form of solution obtained by diluting the agent with an organic solvent, is mechanically mixed while sprayed or dropped into the filler (A), and then drying and baking of the surface treatment agent are performed as required. The wet method is a method in which the filler (A) is impregnated with a solution obtained by diluting a predetermined amount of the surface treatment agent with an organic solvent and subjected to stirring and mixing to volatilize the solvent. The integral blend method is a method in which a predetermined amount of the surface treatment agent is added while the polymer and the filler (A) are mixed. Generally in the integral blend method, in view of reactivity with the filler, a relatively large amount of the surface treatment agent is often used, and further, the mixing is often performed under heating.

The amount of the polymer-type surface treatment agent used is preferably from 0.05 to 5% by mass, more preferably from 0.08 to 3% by mass, further preferably from 0.1 to 2% by mass based on the total amount of the filler (A).

Examples of a surface treatment apparatus include a rotation-revolution stirring mixer, a blender, a nauta, a Henschel mixer, and a planetary mixer, and any of these may be used.

The content of the filler (A) surface-treated with the polymer-type surface treatment agent is preferably from 1 to 1000 parts by mass, more preferably from 50 to 980 parts by mass, further preferably from 100 to 970 parts by mass, still further preferably from 200 to 960 parts by mass, still further preferably from 300 to 950 parts by mass, still further preferably from 400 to 950 parts by mass based on 100 parts by mass in total of the castor oil-based polyol and the polyisocyanate compound. When the content of the filler (A) surface-treated with the polymer-type surface treatment agent is 1 part by mass or more, thermally conductive properties can be imparted, and when the content is 1000 parts by mass or less, a urethane resin composition which is liquid before curing can be obtained.

The filler preferably comprises additionally a filler (B) having an average particle diameter of more than 10 μm and 300 μm or less, from the viewpoint of filling properties and thermally conductive properties.

The average particle diameter of the filler (B) is preferably from 15 μm or more and 150 μm or less, more

preferably from 20 μm or more and 120 μm or less.

The filler (B) is not particularly limited as long as its average particle diameter is more than 10 μm to 300 μm or less, and may be appropriately selected from the group consisting of oxides, nitrides, carbides, and hydroxides of metals, silicone, or boron and used. In consideration of the balance between thermal conductivity and costs, aluminum oxide (alumina) is preferable. From the viewpoint of highly thermally conductive properties, aluminum nitride and boron nitride is preferable used, and from the viewpoint of low costs, silica, quartz powder, and aluminum hydroxide are preferable used. From the viewpoint of hydrolytic resistance, preferable is aluminum nitride having a silicon-containing oxide coating on the surface thereof (hereinbelow, also referred to as silicon-containing oxide-coated aluminum nitride).

The silicon-containing oxide coating may cover partially or the entire surface of the aluminum nitride, and preferably covers the entire surface of the aluminum nitride.

Examples of the "silicon-containing oxide" for the silicon-containing oxide coating and silicon-containing oxide-coated aluminum nitride particles include silica, or oxides comprising silicone and aluminum.

In the silicon-containing oxide-coated aluminum nitride, the coverage of the silicon-containing oxide coating that covers the surface of the aluminum nitride as determined by LEIS analysis is preferably from 70% or more and 100% or less, more preferably 70% or more and 95% or less, further preferably 72% or more and 90% or less, particularly preferably 74% or more and 85% or less. When the coverage is 70% or more and 100% or less, the moisture resistance is more excellent. When the coverage exceeds 95%, the thermal conductivity may decrease.

The coverage (%) determined by LEIS (Low Energy Ion Scattering) analysis of the silicon-containing oxide coating ($SiO_2$) that covers the surface of the aluminum nitride can be determined by the following formula:

$$(S_{Al}(AlN) - S_{Al}(AlN + SiO_2))/S_{Al}(AlN) \times 100$$

wherein $S_{Al}(AlN)$ is the area of the Al peak of the aluminum nitride, and $S_{Al}(AlN + SiO_2)$ is the area of the Al peak of the silicon-containing oxide-coated aluminum nitride. The area of the Al peak can be determined from analysis by means of low energy ion scattering (LEIS), which is a measurement method using an ion source and a noble gas as probes. LEIS is a technique using a noble gas of several keV as the incident ion, being an evaluation method permitting a composition analysis of the outermost surface (reference: The TRC News 201610-04 (October 2016)).

An example of a method for forming a silicon-containing oxide coating on aluminum nitride includes a method having a first step of covering the surface of the aluminum nitride with a siloxane compound having a structure represented by the following formula (1), and a second step of heating the aluminum nitride covered with the siloxane compound at a temperature of 300°C or more and 900°C or less.

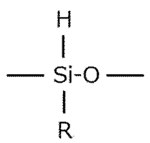

· · · (1)

In the formula (1), R is an alkyl group having 4 or less carbon atoms.

The structure represented by the formula (1) is a hydrogen siloxane structural unit having a Si-H bond. In the formula (1), R is an alkyl group having 4 or less carbon atoms, that is, a methyl group, an ethyl group, a propyl group, or a butyl group, preferably a methyl group, an ethyl group, an isopropyl group, or a t-butyl group, more preferably a methyl group.

As the siloxane compound, preferable is an oligomer or a polymer comprising a structure represented by the formula (1) as a repeating unit. The siloxane compound may be any of linear, branched, or cyclic. The weight average molecular weight of the siloxane compound is preferably from 100 to 2000, more preferably from 150 to 1000, further preferably from 180 to 500, from the viewpoint of ease of formation of a silicon-containing oxide coating having a uniform coating thickness. The weight average molecular weight is a value in terms of polystyrene, obtained by gel permeation chromatography (GPC).

As the siloxane compound, preferably used are/is a compound represented by the following formula (2) and/or a compound represented by the following formula (3).

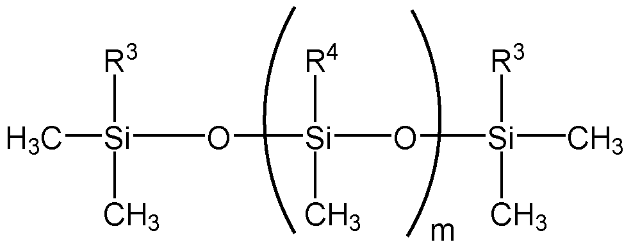

··· (2)

In the formula (2), $R^3$ and $R^4$ are each independently a hydrogen atom or a methyl group, and at least either of $R^3$ and $R^4$ is a hydrogen atom. m is an integer of 0 to 10, and from the viewpoint of commercial availability and the boiling point, is preferably 1 to 5, more preferably 1.

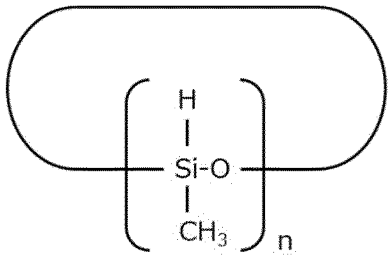

··· (3)

In the formula (3), n is an integer of 3 to 6, preferably from 3 to 5, more preferably 4.

As the siloxane compound, particularly preferable is a cyclic hydrogen siloxane oligomer in which n is 4 in the formula (3), from the viewpoint of ease of formation of a favorable silicon-containing oxide coating.

In the first step, the surface of the aluminum nitride is covered with a siloxane compound having a structure represented by the formula (1).

In the first step, as long as the surface of the aluminum nitride can be covered with a siloxane compound having a structure represented by the formula (1), the process is not particularly limited. Examples of the process for the first step include a dry mixing method in which, using a common powder mixing apparatus, dry mixing is made by adding the siloxane compound by spraying while the raw material aluminum nitride is stirred to thereby coat the aluminum nitride.

Examples of the powder mixing apparatus include a Henschel mixer (manufactured by Nippon Coke & Engineering Co., Ltd.), a rotary vessel-type V blender, a ribbon blender having mixing blades such as a double cone-type blender, a screw-type blender, a hermetic rotary kiln, and stirring by means of a stirring bar of a hermetic container using magnet coupling. The temperature conditions are not particularly limited, and are preferably in the range of 10°C or more and 200°C or less, more preferably in the range of 20°C or more and 150°C or less, further preferably in the range of 40°C or more and 100°C or less.

A vapor phase adsorption method also may be used in which vapor of the siloxane compound singly or a mixed gas thereof with an inert gas such as nitrogen gas is caused to be attached or deposited onto the aluminum nitride surface left to stand. The temperature conditions are not particularly limited, and are preferably in the range of 10°C or more and 200°C or less, more preferably in the range of 20°C or more and 150°C or less, further preferably in the range of 40°C or more and 100°C or less. If further necessary, the inside of the system may be pressurized or depressurized. As an apparatus that can be used in this case, preferable is an apparatus which is a hermetic system and in which the gas in the system can be easily replaced. Examples thereof that can be used include a glass container, a desiccator, and a CVD apparatus.

The amount of the siloxane compound used in the first step is not particularly limited. In the aluminum nitride covered with the siloxane compound obtained in the first step, the amount coated with the siloxane compound is preferably 0.1 mg or more and 1.0 mg or less, more preferably in the range of 0.2 mg or more and 0.8 mg or less, further preferably in the range of 0.3 mg or more and 0.6 mg or less per 1 $m^2$ of the surface area calculated from the specific surface area ($m^2/g$) of the aluminum nitride determined by the BET method. When the amount coated with the siloxane compound is within the range, it is possible to obtain aluminum nitride having a silicon-containing oxide coating having a uniform coating thickness.

The amount coated with the siloxane compound per 1 $m^2$ of the surface area calculated from the specific surface area ($m^2/g$) of the aluminum nitride determined by the BET method can be determined by dividing the difference between the masses of the aluminum nitride before and after coated with the siloxane compound by the surface area ($m^2$) calculated from the specific surface area ($m^2/g$) of the aluminum nitride determined by the BET method.

In the second step, the aluminum nitride coated with the siloxane compound obtained in the first step is heated

at a temperature of 300°C or more and 800°C or less. This enables the silicon-containing oxide coating to be formed on the aluminum nitride surface. The heating temperature is more preferably 400°C or more, further preferably 500°C or more.

From the viewpoint that a sufficient reaction time is secured and also a favorable silicon-containing oxide coating is efficiently formed, the heating time is preferably 30 minutes or more and 6 hours or less, more preferably 45 minutes or more and 4 hours or less, further preferably in the range of 1 hour or more and 2 hours or less. As for the atmosphere at the time of heating treatment, the heating treatment is preferably performed in an atmosphere comprising oxygen gas, for example, in the atmospheric air (in the air).

The particles of the silicon-containing oxide-coated aluminum nitride may be partially fused to one another after the heat treatment in the second step, and in such a case, disintegration using a common pulverizer, for example, a roller mill, a hammer mill, a jet mill, or a ball mill enables silicon-containing oxide-coated aluminum nitride having no sticking or clumping to be obtained.

After completion of the second step, the first step and the second step may be performed in the order mentioned. That is, a step of performing the first step and the second step in the order mentioned may be repeatedly performed.

[Dispersant]

When the thermally conductive urethane resin composition of the present embodiment comprises the filler (B), the filler (B) is preferably surface-treated with a dispersant from the viewpoint of flowability of the urethane resin composition. Examples of the dispersant include polymer dispersants, surfactants, wetting dispersants, and modified silicone oils. Some of these may have a functional group such as a hydroxyl group, an amino group, an amine salt, or a carboxylate in the molecule such as a silicone skeleton or a hydrocarbon skeleton. Of the dispersants, polymer dispersants are preferable from the viewpoint of an improvement in the consistency of the urethane resin composition. These may be used singly or in admixture of two or more.

Examples of commercially available products of the dispersant include "BYK-106" and "BYK-108" manufactured by BYK-Chemie GmbH and "EXP6496D" manufactured by DIC Corporation.

When the dispersant is combined with a surface treatment agent such as alkoxysilane, effects of dispersing the filler and of improving the consistency of the urethane resin composition may be reduced. Furthermore, the dispersant may react with isocyanate, and thus appropriate selection thereof is required.

The dispersant is preferably placed on kneading the filler (B) into the thermally conductive urethane resin composition. That is, the surface of the filler (B) is preferably treated by the integral blend method.

The content of the dispersant is preferably from 0.05 to 5.0 parts by mass, more preferably from 0.1 to 5.0 parts by mass, further preferably from 0.5 to 4.8 parts by mass, still further preferably from 1.0 to 4.8 parts by mass based on 100 parts by mass in total of the castor oil-based polyol and the polyisocyanate compound, from the viewpoint of an improvement in the consistency of the urethane resin composition.

The content of the filler (B) is preferably from 300 to 3000 parts by mass, more preferably from 350 to 2500 parts by mass, further preferably from 400 to 2000 parts by mass, still further preferably from 450 to 1500 parts by mass, still further preferably from 500 to 1000 parts by mass based on 100 parts by mass in total of the castor oil-based polyol and the polyisocyanate compound. When the content of the filler (B) is 300 parts by mass or more, the thermally conductive properties can be made higher, and when the content is 3000 parts by mass or less, the urethane resin composition is allowed to have flowability.

[Other fillers]

The thermally conductive urethane resin composition of the present embodiment may contain other fillers in addition to the filler (A) and filler (B). The other fillers may be surface-treated with a surface treatment agent other than the polymer-type surface treatment agent. Examples of the surface treatment agent include silane coupling agents other than the polymer-type surface treatment agent, titanium coupling agents, aluminum coupling agents, higher alcohols, medium chain fatty acids, long chain fatty acids, fatty acid ester, acidic phosphoric acid esters, phosphorous acid esters, alkylbenzoic acids, and alkylbenzoic acid esters. Surface treatment agents that do not react with the polyisocyanate compound are preferable, and one can be appropriately selected from these and used. These may be used singly or in admixture of two or more.

When other fillers are surface-treated with a surface treatment agent other than the polymer-type surface treatment agent, the amount thereof used is preferably from 0.05 to 5% by mass, more preferably from 0.08 to 3% by mass, further preferably from 0.1 to 2% by mass based on the total amount of the other fillers.

The content of the other fillers surface-treated with a surface treatment agent other than the polymer-type surface treatment agent is preferably 20% by mass or less, more preferably 10% by mass or less, further preferably 0% by mass based on the total amount of the fillers, from the viewpoint of hydrolytic resistance.

The urethane resin composition of the present embodiment may additionally comprise a reaction accelerator.

Although organic tin compounds have been conventionally used as the reaction accelerator for urethanation reaction, some substances among the organic tin compounds are regulated due to their toxicity. For this reason, it is desirable not to use an organic tin compound as much as possible.

Examples of the reaction accelerator used in the present embodiment include organometallic compounds such as organotitanium compounds, organoaluminum compounds, organozirconium compounds, organobismuth compounds, organotungsten compounds, organomolybdenum compounds, organocobalt compounds, organozinc compounds, organopotassium compounds, and organoiron compound; and amine compounds such as 1,8-diazabicyclo[5.4.0]undecene-7 (DBU) and 1,5-diazabicyclo[4.3.0]nonene-5 (DBN). These may be used singly or in admixture of two or more.

When a surface treatment agent having a trialkoxy group is used as the surface treatment agent for the filler, the surface treatment agent causes a condensation reaction with an organometallic compound, an amine compound, or the like to generate a bond other than polymer and isocyanate. Thus, the hardness of the cured product may increase, or the preservability of the urethane resin composition may be lowered. In order to prevent these, countermeasures are required to be appropriately taken such as, not adding a reaction accelerator depending on the surface treatment agent, or selection of the surface treatment agent, or removal of water from the system.

When a reaction accelerator is used, the content thereof is preferably from 0.002 to 0.030% by mass, more preferably from 0.004 to 0.025% by mass, further preferably from 0.006 to 0.020% by mass based on the total amount of the urethane resin composition. When the content of the reaction accelerator within the range described above, the urethane resin composition is cured more favorably.

The urethane resin composition of the present embodiment may further comprise a plasticizer. Examples of the plasticizer include polymers derived from castor oil having no functional group (provided that castor oil-based polyols are excluded), carboxylic acid esters, polyphosphoric acid esters, trimellitic acid esters, polybutene, and $\alpha$-olefins. When the urethane resin composition is caused to contain a plasticizer, the viscosity of the urethane resin composition can be reduced, and also the hardness of a cured product can be lowered.

When the urethane resin composition of the present embodiment contains a plasticizer, the content thereof is preferably 50 parts by mass or less, more preferably 30 parts by mass or less based on 100 parts by mass in total of the castor oil-based polyol and polyisocyanate compound. When the content of the plasticizer is 50 parts by mass or less, it is possible to inhibit occurrence of oil bleeding and weakening of a cured product. The lower limit of the content of the plasticizer is preferably 5 parts by mass.

The urethane resin composition of the present embodiment may further comprise a retarder. Examples of the retarder include acidic compounds such as acidic phosphoric acid esters (provided that ones corresponding to flame retardants mentioned below are excluded), phosphorous acid esters, alkylbenzoic acids, alkylbenzoic acid esters, carboxylic acids, and hydrochloric acid. Addition of an unintentionally acidulated filler is also effective. Specific examples thereof include fillers treated with a chlorosilane compound, fillers of which the alkali content is washed with hydrochloric acid or sulfuric acid, fillers treated with phosphoric acid or a phosphoric acid ester, and fillers treated with a fatty acid such as stearic acid.

Here, phosphoric acid, phosphoric acid esters, fatty acids, and the like may be used as a surface treatment agent for the filler. When a filler treated therewith is added, care should be taken because further adding a retarder may prevent progress of curing reaction.

When a retarder is used, the amount thereof added is preferably from 0.001 to 0.5 parts by mass based on 100 parts by mass in total of the castor oil-based polyol and polyisocyanate compound.

To the urethane resin composition of the present embodiment, additives such as a flame retardant, an antifoaming agent, a heat-resistant stabilizer, and a pigment can be blended as required in addition to the components above, without impairing the effects of the present invention.

When the additives are used, the amount of each of the additives added is preferably from 0.1 to 6.0 parts by mass, more preferably from 0.2 to 5.0 parts by mass based on 100 parts by mass in total of the castor oil-based polyol and polyisocyanate compound.

Examples of the flame retardant include hydroxides such as calcium hydroxide; oxides such as molybdenum oxide and boron oxide; carbon; phosphorus compounds; and phosphoric acid compounds such as ammonium phosphate and phosphoric acid esters; provided that ones corresponding to the filler are excluded. These may be used singly or in admixture of two or more. The urethane resin is susceptible to moisture, and thus a hydroxide or carbon is used as much as possible.

The antifoaming agent is not particularly limited, and examples of thereof include silicone compounds, fluorine compounds, high molecular polymers, and fatty acid esters. Provided that ones corresponding to the dispersant are excluded. Preferable antifoaming agents are ones that do not react with the polyisocyanate compound or the reaction accelerator. These may be used singly or in admixture of two or more.

Examples of the heat-resistant stabilizer include oxides such as zirconium oxide, cerium oxide, or composite oxides thereof (provided that ones corresponding to the filler and the flame retardant are excluded), carbon, phenolic

compounds, sulfur compounds, phosphorus compounds, amine compounds, and imidazole compounds. These may be used singly or in admixture of two or more. Particularly, combinations of a phenolic compound and a sulfur compound are preferable.

Some of the fillers serves as a flame retardant and a heat-resistant stabilizer. The carbon and phosphorus compounds serves as a flame retardant and a heat-resistant stabilizer.

In the urethane resin composition of the present embodiment, the total content of the castor oil-based polyol, the polyisocyanate compound, and the filler is preferably from 80 to 100% by mass, more preferably from 90 to 100% by mass, further preferably from 95 to 100% by mass.

<Production of thermally conductive urethane resin composition>

When the filler (A) and filler (B) are surface-treated by the integral blend method, for example, the polymer-type surface treatment agent, the filler (A), and the filler (B) are added to the castor oil-based polyol and the polyisocyanate compound and kneaded while heated to 80 to 120°C. Further, the mixture is kneaded under reduced pressure and once cooled to room temperature (23°C). Then, a dispersant is added thereto and the mixture is further kneaded to enable a thermally conductive urethane resin composition of the present embodiment to be obtained. Before kneaded with each of the components, the polyisocyanate compound may be allowed to react with a portion of the castor oil-based polyol to become an isocyanate-terminated prepolymer. Alternatively, instead of the filler (A), a filler (A) surface-treated preliminarily with the polymer-type surface treatment agent by the dry method or wet method may be used.

Each of the components can be kneaded using a rotation-revolution stirring mixer, a blender, a nauta, a Henschel mixer, a planetary mixer, or the like.

The consistency at 23°C of the urethane resin composition of the present embodiment is preferably from 290 to 400, more preferably from 300 to 380, further preferably from 305 to 370, from the viewpoint of flowability. When the consistency of the urethane resin composition is 400 or less, sedimentation of the filler during preservation can be inhibited. When the consistency is 290 or more, printing and an application work can be performed while the coating thickness of the urethane resin composition is made larger.

The consistency herein is an index indicating the flexibility of a urethane resin composition, and a larger value thereof indicates a softer urethane resin composition.

The consistency can be measured by a method in accordance with JIS K2220:2013, and specifically can be measured by the method described in examples.

<Curing reaction of thermally conductive urethane resin composition>

The urethane resin composition of the present embodiment is poured into a mold or the like, dried as required, and then cured at room temperature (23°C) or under heating to thereby enable a cured product made of the urethane resin composition to be obtained. The drying may be performed at normal temperature or may be natural drying. The heating is preferably performed at a temperature of 50 to 100°C for 30 minutes to 20 hours, more preferably performed at a temperature of 60 to 90°C for 1 to 10 hours.

The thermal conductivity of a cured product of the urethane resin composition of the present embodiment is preferably 3.0 W/m·K or more, more preferably 3.5 W/m·K or more, further preferably 4.0 W/m·K or more. The thermal conductivity of the cured product can be set to 3.0 W/m·K or more by appropriately adjusting the type and content of the filler(s).

The thermal conductivity can be measured in accordance with ISO 20020-2, and specifically can be measured by the method described in examples.

The Shore 00 hardness of the cured product of the urethane resin composition of the present embodiment measured in accordance with ASTM D2240 is preferably from 20 to 97, more preferably from 50 to 97, further preferably from 60 to 97. When the hardness of the cured product is within the range, the cured product can have a moderate hardness.

The hardness can be measured specifically by the method described in examples.

The manner in which the reaction occurs on giving the cured product of the urethane resin composition is widely varied, such as a reaction between the castor oil-based polyol and the polyisocyanate compound, a reaction between the castor oil-based polyol and the polymer-type surface treatment agent, and a reaction between the polyisocyanate compound and the polymer-type surface treatment agent, and thus it is not possible to comprehensively describe specific aspects based on such combinations. Accordingly, it can be said that direct identification of the cured product of the urethane resin composition by its structure or characteristic is impossible or impractical.

With the urethane resin composition of the present embodiment, it is possible to lower the hardness while maintaining the highly thermally conductive properties, and to give a cured product excellent in hydrolytic resistance. Accordingly, cured products of the urethane resin composition of the present embodiment can be suitably used in heat

generating electronic components such as electronic devices, personal computers, and ECUs and batteries for automobiles, and heat dissipation sheets.

Examples

Next, the present invention will be described concretely with reference to examples, but the present invention is in no way limited to these examples.
The details of each of components described in Tables 1 to 4, used for preparation of thermally conductive urethane resin compositions, are as follows.

[Synthesis Example 1: Preparation of silicon-containing oxide-coated aluminum nitride]

Using a vacuum desiccator that was made of an acrylic resin having a plate thickness of 20 mm, had inner dimensions of 260 mm × 260 mm × 100 mm, and had a structure having two, upper and lower, stages divided by a partition having through holes, 100 g of aluminum nitride (FAN-f80-A1 manufactured by Furukawa Denshi Co., Ltd., average particle diameter: 80 μm, specific surface area (BET method): 0.05 $m^2/g$) uniformly spread on a stainless tray was left to stand on the upper stage, and 30 g of 1,3,5,7-tetramethylcyclotetrasiloxane (manufactured by Tokyo Chemical Industry Co., Ltd.) placed in a glass petri dish was left to stand on the lower stage. Thereafter, the vacuum desiccator was closed and heated in an oven at 80°C for 30 hours. The operation was performed with safety measures taken, such as release of hydrogen gas generated by the reaction from the open valve attached to the desiccator. Next, the sample taken out of the desiccator was placed in an alumina crucible. The sample was subjected to heat treatment in the atmospheric air under conditions of 650°C and 3 hours to obtain silicon-containing oxide-coated aluminum nitride. The average particle diameter of the resulting silicon-containing oxide-coated aluminum nitride was determined to be 80 μm from the particle diameter at an integrated volume of 50% (50% particle diameter: D50) in the particle size distribution measured using a laser diffraction-type particle size analyzer (manufactured by MicrotracBEL Corp., trade name: MT3300EXII). The coverage of the silicon-containing oxide coating that covers the surface of the aluminum nitride as determined by LEIS analysis was 76%.

[Castor oil-based polyol]

- Castor oil-based polyol 1 hydroxyl value: 23.2 mgKOH/g, acid value: 3.3 mgKOH/g, viscosity at 25°C: 78 mPa·s, moisture content: 0.01% or less, the number of hydroxyl groups: 2

[Polyisocyanate compound]

- Isocyanate compound 1: URIC N-2023 (isocyanate-terminated prepolymer), manufactured by Itoh Oil Chemicals Co., Ltd., viscosity at 25°C: 2290 mPa·s, NCO content: 16% by mass

[Filler (A2)]

- Filler 1 (aluminum hydroxide): BF013, manufactured by Nippon Light Metal Company, Ltd., average particle diameter: 1.2 μm, specific surface area (BET method): 4.5 $m^2/g$

[Filler (A2)]

- Filler 2 (aluminum hydroxide): BF083, manufactured by Nippon Light Metal Company, Ltd., average particle diameter: 10 μm, specific surface area (BET method): 0.7 $m^2/g$

[Filler (A1)]

- Filler 3 (alumina): AES-12, manufactured by Sumitomo Chemical Company, Limited, average particle diameter: 0.5 μm, specific surface area (BET method): 5.8 $m^2/g$

[Filler (A2)]

- Filler 4 (alumina): BAK-5, manufactured by Shanghai Bestry Performance Materials Co., Ltd., average particle diameter: 5 μm, specific surface area (BET method): 0.4 $m^2/g$

The average particle diameter and specific surface area of each of the fillers 1 to 4 and fillers 9 and 10 mentioned below were measured by the following measurement methods.

(1) Average particle diameter

The average particle diameter was determined from the particle diameter at an integrated volume of 50% (50% particle diameter: D50) in the particle size distribution measured using a laser diffraction-type particle size analyzer (manufactured by MicrotracBEL Corp., trade name: MT3300EXII).

(2) Specific surface area

The specific surface area was measured using a specific surface area measurement apparatus (manufactured by Mountech Co., Ltd., trade name: Macsorb MS30) by the single point BET method based on nitrogen adsorption.

[Surface treatment method for filler]

(1) Surface treatment of filler with polymer-type surface treatment agent

Surface treatment of the fillers using a polymer-type surface treatment agent was performed in accordance with the following procedure.

1 part by mass of a polymer-type surface treatment agent [Dynasylan (R) SIVO408, manufactured by Evonik Industries AG, viscosity at 25°C: 35 mPa·s, specific gravity: 1.04] was weighed with respect to 100 parts by mass of each of the fillers, placed in a rotation-revolution mixer (manufactured by THINKY CORPORATION, trade name: ARV-310P), and stirred and mixed at a rotation speed of 1000 rpm for 30 seconds, a loosening operation was repeated 4 times. Thereafter, the mixture was heated in a hot air circulating oven at a temperature of 120°C for 2 hours and air-dried.

(2) Surface treatment of filler with alkoxysilane

Surface treatment of the fillers using alkoxysilane was performed in accordance with the following procedure.

A value obtained by multiplying 100 parts by mass of each of the fillers with the specific surface area of each of the fillers and dividing the product by the minimum area coated with each alkoxysilane was weighed as the content of the each of alkoxysilanes and added. An agent was prepared by adding 5 parts by mass of ethanol with respect to 100 parts by mass of each of the fillers and further adding water in an amount half of a value obtained by multiplying 100 parts by mass of the filler with the specific surface area of each of the fillers and dividing the product by the minimum area coated with each alkoxysilane, which agent was added to each of the fillers. After stirring and mixing in a rotation-revolution mixing mixer (manufactured by THINKY CORPORATION, trade name: ARV-310P) at a rotation speed of 1000 rpm for 30 seconds, a loosening operation was repeated 4 times, and the mixture was once air-dried. Next, the air-dried mixture was in heated a hot air circulating oven at a temperature of 120°C for 2 hours followed by cooling.

(3) Surface treatment of filler with carboxylic acid or carboxylic acid ester

Surface treatment of the fillers using a carboxylic acid or carboxylic acid ester was performed in accordance with the following procedure.

0.2 parts by mass of a carboxylic acid or carboxylic acid ester was weighed with respect to 100 parts by mass

of each of the fillers, placed in a rotation-revolution mixer (manufactured by THINKY CORPORATION, trade name: ARV-310P), and stirred and mixed at a rotation speed of 1000 rpm for 30 seconds, a loosening operation was repeated 4 times. Thereafter, the mixture was heated in a hot air circulating oven at a temperature of 120°C for 2 hours and air-dried.

[Filler (A1) surface-treated with polymer-type surface treatment agent]

- Filler 5: surface-treated product obtained by surface-treating the filler 3 with a polymer-type surface treatment agent [Dynasylan (R) SIVO408, manufactured by Evonik Industries AG, compound in which $R^1$ is an ethyl group in the general formula (I), viscosity at 25°C: 35 mPa·s, specific gravity: 1.04]

[Filler (A2) surface-treated with polymer-type surface treatment agent]

- Filler 6: surface-treated product obtained by surface-treating the filler 1 with a polymer-type surface treatment agent [Dynasylan (R) SIVO408, manufactured by Evonik Industries AG, viscosity at 25°C: 35 mPa·s, specific gravity: 1.04]

[Filler (A2) surface-treated with polymer-type surface treatment agent]

- Filler 7: surface-treated product obtained by surface-treating the filler 2 with a polymer-type surface treatment agent [Dynasylan (R) SIVO408, manufactured by Evonik Industries AG, viscosity at 25°C: 35 mPa·s, specific gravity: 1.04]

[Filler (A2) surface-treated with polymer-type surface treatment agent]

- Filler 8: surface-treated product obtained by surface-treating the filler 4 with a polymer-type surface treatment agent [Dynasylan (R) SIVO408, manufactured by Evonik Industries AG, viscosity at 25°C: 35 mPa·s, specific gravity: 1.04]

Viscosities at 25°C of the polymer-type surface treatment agent and alkoxysilanes mentioned below were measured based on JIS Z8803:2011 "Methods for viscosity measurement of liquid" using a BM-type viscometer (manufactured by Toki Sangyo Co., Ltd., trade name: B-10) at 25°C under conditions of rotor No.1 and a rotation rate of 60 rpm.

[Filler (B)]

- Filler 9 (alumina): Alunabeads (R) CB-A70, manufactured by Showa Denko K.K., average particle diameter: 70 μm, specific surface area (BET method): 0.1 $m^2/g$
- Filler 10: silicon-containing oxide-coated aluminum nitride obtained in Synthesis Example 1, average particle diameter: 80 μm, specific surface area (BET method): 0.06 $m^2/g$

[Filler (A) surface-treated with alkoxysilane not having viscosity at 25°C of 10 to 500 mPa·s]

- Filler 11: surface-treated product obtained by surface-treating the filler 1 (filler (A2)) with an alkoxysilane [KBM-3033 (trimethoxypropylsilane), manufactured by Shin-Etsu Chemical Co., Ltd., minimum area coated: 475 $m^2/g$, viscosity at 25°C: 0.7 mPa·s, specific gravity: 0.93]
- Filler 12: surface-treated product obtained by surface-treating the filler 2 (filler (A2)) with an alkoxysilane [KBM-3033 (trimethoxypropylsilane), manufactured by Shin-Etsu Chemical Co., Ltd., minimum area coated: 475 $m^2/g$, viscosity at 25°C: 0.7 mPa·s, specific gravity: 0.93]
- Filler 13: surface-treated product obtained by surface-treating the filler 1 (filler (A2)) with an alkoxysilane [KBM-3063 (trimethoxyhexylsilane), manufactured by Shin-Etsu Chemical Co., Ltd., minimum area coated: 378 $m^2/g$, viscosity

at 25°C: 1.8 mPa·s, specific gravity: 0.92]

- Filler 14: surface-treated product obtained by surface-treating the filler 2 (filler (A2)) with an alkoxysilane [KBM-3063 (trimethoxyhexylsilane), manufactured by Shin-Etsu Chemical Co., Ltd., minimum area coated: 378 $m^2/g$, viscosity at 25°C: 1.8 mPa·s, specific gravity: 0.92]
- Filler 15: surface-treated product obtained by surface-treating the filler 1 (filler (A2)) with an alkoxysilane [Dynasylan (R) OCTEO (triethoxyoctylsilane), manufactured by Evonik Industries AG, minimum area coated: 283 $m^2/g$, viscosity at 25°C: 2.0 mPa·s, specific gravity: 0.88]
- Filler 16: surface-treated product obtained by surface-treating the filler 2 (filler (A2)) with an alkoxysilane [Dynasylan (R) OCTEO (triethoxyoctylsilane), manufactured by Evonik Industries AG, minimum area coated: 283 $m^2/g$, viscosity at 25°C: 2.0 mPa·s, specific gravity: 0.88]
- Filler 17: surface-treated product obtained by surface-treating the filler 1 (filler (A2)) with an alkoxysilane [KBM-3103C (trimethoxydecylsilane), manufactured by Shin-Etsu Chemical Co., Ltd., minimum area coated: 298 $m^2/g$, viscosity at 25°C: 2.3 mPa·s, specific gravity: 0.90]
- Filler 18: surface-treated product obtained by surface-treating the filler 2 (filler (A2)) with an alkoxysilane [KBM-3103C (trimethoxydecylsilane), manufactured by Shin-Etsu Chemical Co., Ltd., minimum area coated: 298 $m^2/g$, viscosity at 25°C: 2.3 mPa·s, specific gravity: 0.90]

[Filler (A) surface-treated with carboxylic acid or carboxylic acid ester]

- Filler 19: surface-treated product obtained by surface-treating the filler 1 (filler (A2)) with lauric acid [Lauric acid 98, manufactured by Miyoshi Oil & Fat Co., Ltd.]
- Filler 20: surface-treated product obtained by surface-treating the filler 2 (filler (A2)) with lauric acid [Lauric acid 98, manufactured by Miyoshi Oil & Fat Co., Ltd.]
- Filler 21: surface-treated product obtained by surface-treating the filler 1 (filler (A2)) with methyl caprate [TOENOL 2010-95, manufactured by Toei Chemical Co., Ltd.]
- Filler 22: surface-treated product obtained by surface-treating the filler 2 (filler (A2)) with methyl caprate [TOENOL 2010-95, manufactured by Toei Chemical Co., Ltd.]

[Filler (A) surface-treated with alkoxysilane not having viscosity at 25°C of 10 to 500 mPa·s]

- Filler 23: surface-treated product obtained by surface-treating the filler 3 (filler (A1)) with an alkoxysilane [KBM-3033 (trimethoxypropylsilane), manufactured by Shin-Etsu Chemical Co., Ltd., minimum area coated: 475 $m^2/g$, viscosity at 25°C: 0.7 mPa·s, specific gravity: 0.93]
- Filler 24: surface-treated product obtained by surface-treating the filler 4 (filler (A2)) with an alkoxysilane [KBM-3033 (trimethoxypropylsilane), manufactured by Shin-Etsu Chemical Co., Ltd., minimum area coated: 475 $m^2/g$, viscosity at 25°C: 0.7 mPa·s, specific gravity: 0.93]
- Filler 25: surface-treated product obtained by surface-treating the filler 3 (filler (A1)) with an alkoxysilane [KBM-3063 (trimethoxyhexylsilane), manufactured by Shin-Etsu Chemical Co., Ltd., minimum area coated: 378 $m^2/g$, viscosity at 25°C: 1.8 mPa·s, specific gravity: 0.92]
- Filler 26: surface-treated product obtained by surface-treating the filler 4 (filler (A2)) with an alkoxysilane [KBM-3063 (trimethoxyhexylsilane), manufactured by Shin-Etsu Chemical Co., Ltd., minimum area coated: 378 $m^2/g$, viscosity at 25°C: 1.8 mPa·s, specific gravity: 0.92]
- Filler 27: surface-treated product obtained by surface-treating the filler 3 (filler (A1)) with an alkoxysilane [Dynasylan (R) OCTEO (triethoxyoctylsilane), manufactured by Evonik Industries AG, minimum area coated: 283 $m^2/g$, viscosity at 25°C: 2.0 mPa·s, specific gravity: 0.88]
- Filler 28: surface-treated product obtained by surface-treating the filler 4 (filler (A2)) with an alkoxysilane [Dynasylan (R) OCTEO (triethoxyoctylsilane), manufactured by Evonik Industries AG, minimum area coated: 283 $m^2/g$, viscosity at 25°C: 2.0 mPa·s, specific gravity: 0.88]
- Filler 29: surface-treated product obtained by surface-treating the filler 3 (filler (A1)) with an alkoxysilane [KBM-3103C (trimethoxydecylsilane), manufactured by Shin-Etsu Chemical Co., Ltd., minimum area coated: 298 $m^2/g$, viscosity at 25°C: 2.3 mPa·s, specific gravity: 0.90]
- Filler 30: surface-treated product obtained by surface-treating the filler 4 (filler (A2)) with an alkoxysilane [KBM-3103C (trimethoxydecylsilane), manufactured by Shin-Etsu Chemical Co., Ltd., minimum area coated: 298 $m^2/g$, viscosity at 25°C: 2.3 mPa·s, specific gravity: 0.90]

[Filler (A) surface-treated with carboxylic acid or carboxylic acid ester]

- Filler 31: surface-treated product obtained by surface-treating the filler 3 (filler (A1)) with stearic acid [STEARIC ACID 98%, manufactured by Miyoshi Oil & Fat Co., Ltd.]
- Filler 32: surface-treated product obtained by surface-treating the filler 4 (filler (A2)) with stearic acid [STEARIC ACID 98%, manufactured by Miyoshi Oil & Fat Co., Ltd.]
- Filler 33: surface-treated product obtained by surface-treating the filler 3 (filler (A1)) with methyl laurate [TOENOL 2012-95, manufactured by Toei Chemical Co., Ltd.]
- Filler 34: surface-treated product obtained by surface-treating the filler 4 (filler (A2)) with methyl laurate [TOENOL 2012-95, manufactured by Toei Chemical Co., Ltd.]
- Filler 35: surface-treated product obtained by surface-treating the filler 3 (filler (A1)) with lauric acid [Lauric acid 98, manufactured by Miyoshi Oil & Fat Co., Ltd.]
- Filler 36: surface-treated product obtained by surface-treating the filler 4 (filler (A2)) with lauric acid [Lauric acid 98, manufactured by Miyoshi Oil & Fat Co., Ltd.]

[Dispersant]

- Dispersant 1: BYK-106 (salt of a polymer having an acid group), manufactured by BYK-Chemie GmbH
- Dispersant 2: EXP6496D (polyester compound), manufactured by DIC Corporation

[Other components]

- Reaction accelerator 1: Borchi (R) Kat315 (organobismuth compound), manufactured by Borchers Inc.
- Antifoaming agent 1: BYK-A535, manufactured by BYK-Chemie GmbH
- Heat-resistant stabilizer 1: AO-50 (octadecyl 3-(3,5-di-tert-butyl-4-hydroxyphenyl)propionate), manufactured by ADEKA Corporation
- Heat-resistant stabilizer 2: AO-412S (bis[3-(dodecylthio)propionic acid]2,2-bis[[3-(dodecylthio)-1-oxopropyloxy]methyl]-1,3-propanediyl), manufactured by ADEKA Corporation
- Pigment 1: MR-270E (red iron oxide), manufactured by Morishita Bengara Kogyo Co., Ltd.
- Pigment 2: KR320 (iron black), manufactured by Toda Kogyo Corp.
- Pigment 3: FTR5551 Blue (blue pigment paste), manufactured by DIC Corporation, polyol paste of 50% by mass cobalt-aluminum composite oxide

(Example 1)

88.48 parts by mass of the castor oil-based polyol 1 as the castor oil-based polyol and 14.71 parts by mass of the dispersant 1 as the dispersant were weighed and added in a container, and once stirred and mixed in a rotation-revolution mixing mixer (manufactured by THINKY CORPORATION, trade name: ARV-310P) at a rotation speed of 1500 rpm for 30 seconds, and as the surface-treated filler (A2), 209.42 parts by mass of the filler 6, and 314.14 parts by mass of the filler 7 were further added thereto, and the resultant was dried at a temperature of 100°C for 30 minutes in a hot air circulating oven. Thereafter, the resultant dried was stirred and mixed in a rotation-revolution mixing mixer at a rotation speed of 2000 rpm for 30 seconds. Thereafter, 523.56 parts by mass of the filler 9 as the filler (B), and 2.09 parts by mass of the antifoaming agent 1, 2.09 parts by mass of the heat-resistant stabilizer 1, 2.09 parts by mass of the heat-resistant stabilizer 2, and 2.09 parts by mass of the pigment 3, as other components, were added thereto, and the resultant was dried at a temperature of 100°C for 30 minutes in a hot air circulating oven. Thereafter, the resultant dried was stirred and mixed in a rotation-revolution mixing mixer at a rotation speed of 2000 rpm for 30 seconds. The mixture was cooled to room temperature (23°C), and 11.52 parts by mass of the polyisocyanate compound 1 as the polyisocyanate compound were added thereto, and immediately thereafter, the resultant was defoamed by stirring in a rotation-revolution mixing mixer at a rotation speed of 2000 rpm for 30 seconds to obtain the thermally conductive urethane resin composition of Example 1.

(Examples 2 to 7 and Comparative Examples 1 to 23)

The thermally conductive urethane resin composition of each of Examples and Comparative Examples was obtained in the same manner as in Example 1 except that the components were replaced by each component of the type and amount blended described in Table 1 to Table 3.

<Evaluation items>

A silicone mold (diameter: 50 mm × depth: 30 mm, 6 cavities) was provided, and the defoamed thermally conductive urethane resin composition was poured thereinto and left to stand for a day at room temperature (23°C) to obtain test specimens (diameter: 50 mm × thickness: 8 mm).

(1) Consistency

The consistency, which is a needle penetration by means of a 1/4 cone described in JIS K2220:2013, was measured using an automatic needle penetration tester (manufactured by Rigo Co., Ltd., RPM-101).

(2) Hardness

The Shore 00 hardness of the test specimens was measured in accordance with ASTM D2240 using a durometer for ultrasoft rubber (manufactured by TECLOCK Co., Ltd., trade name: GS-745G). A hardness of 20 or more and 97 or less is considered acceptable.

(3) Hydrolytic resistance

The Shore 00 hardness measured in (2) was taken as the initial hardness (hardness 1). Thereafter, the test specimens were placed in an autoclave (manufactured by Tomy Seiko Co., Ltd., SS-320) in the atmospheric air and exposed under conditions of a temperature of 121°C, a relative humidity of 100%, and a pressure of 0.2 MPa for 48 hours. The test specimens were taken out after exposure and air-dried for 1 day, and then, the Shore 00 hardness of the test specimens after 48-hour exposure (hardness 2) was measured by the same operation as in (2). The difference between the hardness 2 and the hardness 1 was calculated. With a smaller difference between the hardness 2 and the hardness 1, the hydrolytic resistance is more excellent.

(4) Thermal conductivity

The thermal conductivity of the test specimens was measured in accordance with ISO 20020-2 using a hot disk method thermophysical property measuring apparatus (manufactured by Kyoto Electronics Manufacturing Co., Ltd., trade name: TPS 2500 S). A thermal conductivity of 3.0 W/m·K or more is considered acceptable.

Table 1

| | | Unit | Example 1 | Comparative Example 1 | Comparative Example 2 | Comparative Example 3 | Comparative Example 4 | Comparative Example 5 | Comparative Example 6 | Comparative Example 7 |
|---|---|---|---|---|---|---|---|---|---|---|
| Castor oil-based polyol | Castor oil-based polyol 1 | Parts by mass | 88.48 | 88.48 | 88.48 | 88.48 | 88.48 | 88.48 | 88.48 | 88.48 |
| Polyisocyanate compound | Polyisocyanate compound 1 | Parts by mass | 11.52 | 11.52 | 11.52 | 11.52 | 11.52 | 11.52 | 11.52 | 11.52 |
| Dispersant | Dispersant 1 | Parts by mass | 4.71 | 4.71 | 4.71 | 4.71 | 4.71 | 4.71 | 4.71 | 4.71 |
| Filler (A2) surface-treated with polymer-type surface treatment agent | Filler 6 | Parts by mass | 209.42 | - | - | - | - | - | - | - |
| | Filler 7 | Parts by mass | 314.14 | - | - | - | - | - | - | - |
| Filler (B) | Filler 9 | Parts by mass | 523.56 | 523.56 | 523.56 | 523.56 | 523.56 | 523.56 | 523.56 | 523.56 |

(continued)

| | | Unit | Example 1 | Comparative Example 1 | Comparative Example 2 | Comparative Example 3 | Comparative Example 4 | Comparative Example 5 | Comparative Example 6 | Comparative Example 7 |
|---|---|---|---|---|---|---|---|---|---|---|
| Filler other than fillers (A1) and (A2) surface-treated with polymer-type surface treatment agent and filler (B) | Filler 1 | Parts by mass | - | 209.42 | - | - | - | - | - | - |
| | Filler 2 | Parts by mass | - | 314.14 | - | - | - | - | - | - |
| | Filler 11 | Parts by mass | - | - | 209.42 | - | - | - | - | - |
| | Filler 12 | Parts by mass | - | - | 314.14 | - | - | - | - | - |
| | Filler 13 | Parts by mass | - | - | - | 209.42 | - | - | - | - |
| | Filler 14 | Parts by mass | - | - | - | 314.14 | - | - | - | - |
| | Filler 15 | Parts by mass | - | - | - | - | 209.42 | - | - | - |
| | Filler 16 | Parts by mass | - | - | - | - | 314.14 | - | - | - |
| | Filler 17 | Parts by mass | - | - | - | - | - | 209.42 | - | - |
| | Filler 18 | Parts by mass | - | - | - | - | - | 314.14 | - | - |
| | Filler 19 | Parts by mass | - | - | - | - | - | - | 209.42 | - |
| | Filler 20 | Parts by mass | - | - | - | - | - | - | 314.14 | - |
| | Filler 21 | Parts by mass | - | - | - | - | - | - | - | 209.42 |
| | Filler 22 | Parts by mass | - | - | - | - | - | - | - | 314.14 |

(continued)

| | | Unit | Example 1 | Comparative Example 1 | Comparative Example 2 | Comparative Example 3 | Comparative Example 4 | Comparative Example 5 | Comparative Example 6 | Comparative Example 7 |
|---|---|---|---|---|---|---|---|---|---|---|
| Other components | Antifoaming agent 1 | Parts by mass | 2.09 | 2.09 | 2.09 | 2.09 | 2.09 | 2.09 | 2.09 | 2.09 |
| | Heat-resistant stabilizer 1 | Parts by mass | 2.09 | 2.09 | 2.09 | 2.09 | 2.09 | 2.09 | 2.09 | 2.09 |
| | Heat-resistant stabilizer 2 | Parts by mass | 2.09 | 2.09 | 2.09 | 2.09 | 2.09 | 2.09 | 2.09 | 2.09 |
| | Pigment 3 | Parts by mass | 2.09 | 2.09 | 2.09 | 2.09 | 2.09 | 2.09 | 2.09 | 2.09 |
| Equivalent ratio [NCO/OH] | | - | 1.2 | 1.2 | 1.2 | 1.2 | 1.2 | 1.2 | 1.2 | 1.2 |
| Consistency (1/4 cone) | | - | 370 | 316 | 297 | 280 | 270 | 264 | 352 | 350 |
| Hardness 1 Shore 00 hardness (initial) | | - | 84 | 83 | 83 | 63 | 65 | 67 | 73 | 70 |
| Hardness 2 Shore 00 hardness (after 48-hour exposure) | | - | 79 | 53 | 55 | 40 | 30 | 25 | 46 | 45 |
| Hydrolytic resistance Difference in hardness (\|hardness 1 - hardness 2\|) | | - | 5 | 30 | 28 | 23 | 35 | 42 | 27 | 25 |
| Thermal conductivity | | W/m·k | 3.03 | 3.01 | 3.05 | 3.03 | 3.01 | 3.01 | 3.05 | 3.02 |

Table 2

| | | Unit | Example 2 | Comparative Example 8 | Comparative Example 9 | Comparative Example 10 | Comparative Example 11 | Comparative Example 12 | Comparative Example 13 | Comparative Example 14 |
|---|---|---|---|---|---|---|---|---|---|---|
| Castor oil-based polyol | Castor oil-based polyol 1 | Parts by mass | 88.48 | 88.48 | 88.48 | 88.48 | 88.48 | 88.48 | 88.48 | 88.48 |
| Polyisocyanate compound | Polyisocyanate compound 1 | Parts by mass | 11.52 | 11.52 | 11.52 | 11.52 | 11.52 | 11.52 | 11.52 | 11.52 |
| Dispersant | Dispersant 1 | Parts by mass | 4.71 | 4.71 | 4.71 | 4.71 | 4.71 | 4.71 | 4.71 | 4.71 |
| Filler (A1) surface-treated with polymer-type surface treatment agent | Filler 5 | Parts by mass | 314.14 | - | - | - | - | - | - | - |
| Filler (A2) surface-treated with polymer-type surface treatment agent | Filler 8 | Parts by mass | 418.85 | - | - | - | - | - | - | - |
| Filler (B) | Filler 9 | Parts by mass | 837.70 | 837.70 | 837.70 | 837.70 | 837.70 | 837.70 | 837.70 | 837.70 |

(continued)

| | | Unit | Example 2 | Comparative Example 8 | Comparative Example 9 | Comparative Example 10 | Comparative Example 11 | Comparative Example 12 | Comparative Example 13 | Comparative Example 14 |
|---|---|---|---|---|---|---|---|---|---|---|
| Filler other than fillers (A1) and (A2) surface-treated with polymer-type surface treatment agent and filler (B) | Filler 3 | Parts by mass | - | 314.14 | - | - | - | - | - | - |
| | Filler 4 | Parts by mass | - | 418.85 | - | - | - | - | - | - |
| | Filler 23 | Parts by mass | - | - | 314.14 | - | - | - | - | - |
| | Filler 24 | Parts by mass | - | - | 418.85 | - | - | - | - | - |
| | Filler 25 | Parts by mass | - | - | - | 314.14 | - | - | - | - |
| | Filler 26 | Parts by mass | - | - | - | 418.85 | - | - | - | - |
| | Filler 27 | Parts by mass | - | - | - | - | 314.14 | - | - | - |
| | Filler 28 | Parts by mass | - | - | - | - | 418.85 | - | - | - |
| | Filler 29 | Parts by mass | - | - | - | - | - | 314.14 | - | - |
| | Filler 30 | Parts by mass | - | - | - | - | - | 418.85 | - | - |
| | Filler 31 | Parts by mass | - | - | - | - | - | - | 314.14 | - |
| | Filler 32 | Parts by mass | - | - | - | - | - | - | 418.85 | - |
| | Filler 33 | Parts by mass | - | - | - | - | - | - | - | 314.14 |
| | Filler 34 | Parts by mass | - | - | - | - | - | - | - | 418.85 |

(continued)

| | | Unit | Example 2 | Comparative Example 8 | Comparative Example 9 | Comparative Example 10 | Comparative Example 11 | Comparative Example 12 | Comparative Example 13 | Comparative Example 14 |
|---|---|---|---|---|---|---|---|---|---|---|
| Other components | Antifoaming agent 1 | Parts by mass | 2.09 | 2.09 | 2.09 | 2.09 | 2.09 | 2.09 | 2.09 | 2.09 |
| | Pigment 1 | Parts by mass | 0.52 | 0.52 | 0.52 | 0.52 | 0.52 | 0.52 | 0.52 | 0.52 |
| | Heat-resistant stabilizer 1 | Parts by mass | 2.09 | 2.09 | 2.09 | 2.09 | 2.09 | 2.09 | 2.09 | 2.09 |
| | Heat-resistant stabilizer 2 | Parts by mass | 2.09 | 2.09 | 2.09 | 2.09 | 2.09 | 2.09 | 2.09 | 2.09 |
| Equivalent ratio [NCO/OH] | | - | 1.2 | 1.2 | 1.2 | 1.2 | 1.2 | 1.2 | 1.2 | 1.2 |
| Consistency (1/4 cone) | | - | 305 | 354 | 337 | 284 | 213 | 218 | 202 | 346 |
| Hardness 1 Shore 00 hardness (initial) | | - | 63 | 70 | 60 | 58 | 44 | 40 | 47 | 55 |
| Hardness 2 Shore 00 hardness (after 48-hour exposure) | | - | 55 | 45 | 25 | 20 | 12 | 12 | 11 | 20 |
| Hydrolytic resistance Difference in hardness (\|hardness 1 - hardness 2\|) | | - | 8 | 25 | 35 | 38 | 32 | 28 | 36 | 35 |
| Thermal conductivity | | W/m·k | 4.12 | 4.15 | 4.15 | 4.15 | 4.13 | 4.12 | 4.12 | 4.13 |

According to Table 1 and Table 2, it can be seen that the cured products of the urethane resin compositions that comprise a filler(s) surface-treated with a polymer-type alkoxysilane surface treatment agent having a viscosity at 25°C within a specific range and of which the equivalent ratio [NCO/OH] is within a specific range enable the hardness to be low while maintaining highly thermally conductive properties and are excellent in hydrolytic resistance (Example 1 and Example 2). In contrast, it can be seen that all of the cured products of the urethane resin compositions that comprise a filler not surface-treated and a filler surface-treated with an alkoxysilane, a fatty acid, and a fatty acid ester have a large difference between the initial hardness and the hardness after 48-hour exposure and are inferior in hydrolytic resistance (Comparative Examples 1 to 14). It is presumed that a large number of carbon atoms of the surface treatment agent leads to steric hindrance, then polymerization is unlikely to proceed, a crosslinked siloxane layer that firmly binds to the filler is unlikely to cover the entire filler, and thus the hydrolytic resistance is inferior.

Table 3

| | | Unit | Ex. 3 | Comp. Ex. 15 | Comp. Ex. 16 | Comp. Ex. 17 | Comp. Ex. 18 | Comp. Ex. 19 | Comp. Ex. 20 | Ex. 4 | Ex. 5 | Comp. Ex.21 | Comp. Ex. 22 | Ex. 6 | Ex. 7 | Comp. Ex. 23 |
|---|---|---|---|---|---|---|---|---|---|---|---|---|---|---|---|---|
| Castor oil-based polyol | Castor oil-based polyol 1 | Parts by mass | 88.48 | 88.48 | 88.48 | 88.48 | 88.48 | 88.48 | 88.48 | 88.48 | 90.31 | 91.88 | 92.93 | 87.70 | 86.13 | 83.77 |
| Polyisocyanate compound | Polyisocyanate compound 1 | Parts by mass | 11.52 | 11.52 | 11.52 | 11.52 | 11.52 | 11.52 | 11.52 | 11.52 | 9.69 | 8.12 | 7.07 | 12.30 | 13.87 | 16.23 |
| Dispersant | Dispersant 2 | Parts by mass | 4.71 | 4.71 | 4.71 | 4.71 | 4.71 | 4.71 | 4.71 | 4.71 | 4.71 | 4.71 | 4.71 | 4.71 | 4.71 | 4.71 |
| Filler (A1) surface-treated with polymer-type surface treatment agent | Filler 5 | Parts by mass | 418.85 | - | - | - | - | - | - | 418.85 | 418.85 | 418.85 | 418.85 | 418.85 | 418.85 | 418.85 |
| Filler (A2) surface-treated with polymer-type surface treatment agent | Filler 8 | Parts by mass | 523.56 | - | - | - | - | - | - | 523.56 | 523.56 | 523.56 | 523.56 | 523.56 | 523.56 | 523.56 |
| Filler (B) | Filler 10 | Parts by mass | 837.70 | 837.70 | 837.70 | 837.70 | 837.70 | 837.70 | 837.70 | 837.70 | 837.70 | 837.70 | 837.70 | 837.70 | 837.70 | 837.70 |
| | Filler 3 | Parts by mass | - | 418.85 | - | - | - | - | - | - | - | - | - | - | - | - |
| | Filler 4 | Parts by mass | - | 523.56 | - | - | - | - | - | - | - | - | - | - | - | - |
| | Filler 23 | Parts by mass | - | - | 418.85 | - | - | - | - | - | - | - | - | - | - | - |

(continued)

| | | Unit | Ex. 3 | Comp. Ex. 15 | Comp. Ex. 16 | Comp. Ex. 17 | Comp. Ex. 18 | Comp. Ex. 19 | Comp. Ex. 20 | Ex. 4 | Ex. 5 | Comp. Ex.21 | Comp. Ex. 22 | Ex. 6 | Ex. 7 | Comp. Ex. 23 |
|---|---|---|---|---|---|---|---|---|---|---|---|---|---|---|---|---|
| Filler other than fillers (A1) and (A2) surface-treated with polymer-type surface treatment agent and filler (B) | Filler 24 | Parts by mass | - | - | 523.56 | - | - | - | - | - | - | - | - | - | - | - |
| | Filler 25 | Parts by mass | - | - | - | 418.85 | - | - | - | - | - | - | - | - | - | - |
| | Filler 26 | Parts by mass | - | - | - | 523.56 | - | - | - | - | - | - | - | - | - | - |
| | Filler 27 | Parts by mass | - | - | - | - | 418.85 | - | - | - | - | - | - | - | - | - |
| | Filler 28 | Parts by mass | - | - | - | - | 523.56 | - | - | - | - | - | - | - | - | - |
| | Filler 29 | Parts by mass | - | - | - | - | - | 418.85 | - | - | - | - | - | - | - | - |
| | Filler 30 | Parts by mass | - | - | - | - | - | 523.56 | - | - | - | - | - | - | - | - |
| | Filler 35 | Parts by mass | - | - | - | - | - | - | 418.85 | - | - | - | - | - | - | - |

(continued)

| | | Unit | Ex. 3 | Comp. Ex. 15 | Comp. Ex. 16 | Comp. Ex. 17 | Comp. Ex. 18 | Comp. Ex. 19 | Comp. Ex. 20 | Ex. 4 | Ex. 5 | Comp. Ex.21 | Comp. Ex. 22 | Ex. 6 | Ex. 7 | Comp. Ex. 23 |
|---|---|---|---|---|---|---|---|---|---|---|---|---|---|---|---|---|
| | Filler 36 | Parts by mass | - | - | - | - | - | - | 523.56 | - | - | - | - | - | - | - |
| Other components | Pigment 2 | Parts by mass | 2.09 | 2.09 | 2.09 | 2.09 | 2.09 | 2.09 | 2.09 | 2.09 | 2.09 | 2.09 | 2.09 | 2.09 | 2.09 | 2.09 |
| | Antifoaming agent 1 | Parts by mass | 1.05 | 1.05 | 1.05 | 1.05 | 1.05 | 1.05 | 1.05 | 1.05 | 1.05 | 1.05 | 1.05 | 1.05 | 1.05 | 1.05 |
| | Heat-resistant stabilizer 1 | Parts by mass | 2.09 | 2.09 | 2.09 | 2.09 | 2.09 | 2.09 | 2.09 | 2.09 | 2.09 | 2.09 | 2.09 | 2.09 | 2.09 | 2.09 |
| | Heat-resistant stabilizer 2 | Parts by mass | 2.09 | 2.09 | 2.09 | 2.09 | 2.09 | 2.09 | 2.09 | 2.09 | 2.09 | 2.09 | 2.09 | 2.09 | 2.09 | 2.09 |
| | Reaction accelerator 1 | Parts by mass | - | - | - | - | - | - | - | 0.21 | - | - | - | - | - | - |
| Equivalent ratio [NCO/OH] | | - | 1.2 | 1.2 | 1.2 | 1.2 | 1.2 | 1.2 | 1.2 | 1.2 | 1.0 | 0.7 | 0.5 | 1.3 | 1.5 | 1.8 |
| Consistency (1/4 cone) | | - | 371 | 308 | 360 | 357 | 326 | 298 | 347 | 365 | 370 | 372 | 375 | 354 | 350 | 343 |
| Hardness 1 Shore 00 hardness (initial) | | - | 91 | 97 | 90 | 94 | 70 | _*1 | 85 | 96 | 72 | 62 | 51 | 97 | 97 | 99 |
| Hardness 2 Shore 00 hardness (after 48-hour exposure) | | - | 75 | 66 | 60 | 51 | 29 | _*1 | 55 | 80 | 55 | 41 | 21 | 85 | 85 | 89 |
| Hydrolytic resistance Difference in hardness (\|hardness 1 - hardness 2\|) | | - | 16 | 31 | 30 | 43 | 41 | _*1 | 30 | 16 | 17 | 21 | 30 | 12 | 12 | 10 |
| Thermal conductivity | | W/m·k | 7.32 | 7.36 | 7.27 | 7.24 | 7.24 | _*1 | 7.22 | 7.21 | 7.23 | 7.17 | 7.18 | 7.25 | 7.26 | 7.28 |
| *1: Unmeasurable because of not being vulcanized | | | | | | | | | | | | | | | | |

According to Table 3, it can be seen that the cured products of the urethane resin compositions that comprise a filler(s) surface-treated with a polymer-type alkoxysilane surface treatment agent having a viscosity at 25°C within a specific range and of which the equivalent ratio [NCO/OH] is within the range of 0.8 to 1.6 enable the hardness to be low while maintaining highly thermally conductive properties and are excellent in hydrolytic resistance (Examples 3 to 7). In contrast, it can be seen that the cured product of the urethane resin composition having an equivalent ratio [NCO/OH] of 0.5 has a large difference between the initial hardness and the hardness after 48-hour exposure and is inferior in hydrolytic resistance (Comparative Example 22) and that the cured product of the urethane resin composition having an equivalent ratio [NCO/OH] of 1.8 has a hardness (initial) of 99 and is markedly hard (Comparative Example 23).

(Reference Example 1)

100 parts by mass of the castor oil-based polyol 1 as the castor oil-based polyol and 5.33 parts by mass of the dispersant 2 as the dispersant were weighed and added in a container, and once stirred and mixed in a rotation-revolution mixing mixer (manufactured by THINKY CORPORATION, trade name: ARV-310P) at a rotation speed of 1500 rpm for 30 seconds, and 473.37 parts by mass of the filler 5 as (A1) filler and 591.72 parts by mass of the filler 8 as (A2) filler were further added thereto, and the resultant was dried at a temperature of 100°C for 30 minutes in a hot air circulating oven. Thereafter, the resultant dried was stirred and mixed in a rotation-revolution mixing mixer at a rotation speed of 2000 rpm for 30 seconds. Thereafter, 946.75 parts by mass of the filler 10 as the filler (B), and 1.18 parts by mass of the pigment 2, 2.37 parts by mass of the antifoaming agent 1, 2.37 parts by mass of the heat-resistant stabilizer 1, and 2.37 parts by mass of heat-resistant stabilizer 2, as other components, were added thereto, and the resultant was dried at a temperature of 100°C for 30 minutes in a hot air circulating oven. Thereafter, the resultant dried was stirred and mixed in a rotation-revolution mixing mixer at a rotation speed of 20000 rpm for 30 seconds to obtain the resin composition of Reference Example 1.

(Reference Example 2)

The resin composition of Reference Example 2 was obtained in the same manner as in Reference Example 1 expect that 0.24 parts by mass of the reaction accelerator 1 were further added as the other component.

<Evaluation items>

(1) Consistency (initial, after 7 days, after 40 days)

A silicone mold (diameter: 50 mm × depth: 30 mm, 6 cavities) was provided, and the defoamed resin composition was poured thereinto and left to stand for a day at room temperature (23°C) to obtain test specimens (diameter: 50 mm × thickness: 8 mm).

The resulting test specimen was used to measure its needle penetration by means of a 1/4 cone described in JIS K2220:2013 using an automatic needle penetration tester (manufactured by Rigo Co., Ltd., RPM-101), and the needle penetration was taken as the consistency (initial). The consistency after the test specimens was left to stand at 23°C 50±10% RH for 7 days and the consistency after the test specimens were left to stand at 23°C 50±10% RH for 40 days were each measured in the same manner as the operation.

Table 4

| | | Unit | Reference Example 1 | Reference Example 2 |
|---|---|---|---|---|
| Castor oil-based polyol | Castor oil-based polyol 1 | Parts by mass | 100 | 100 |
| Polyisocyanate compound | Polyisocyanate compound 1 | Parts by mass | - | - |
| Dispersant | Dispersant 2 | Parts by mass | 5.33 | 5.33 |
| Filler (A1) surface-treated with polymer-type surface treatment agent | Filler 5 | Parts by mass | 473.37 | 473.37 |
| Filler (A2) surface-treated with polymer-type surface treatment agent | Filler 8 | Parts by mass | 591.72 | 591.72 |

(continued)

| | | Unit | Reference Example 1 | Reference Example 2 |
|---|---|---|---|---|
| Filler (B) | Filler 10 | Parts by mass | 946.75 | 946.75 |
| Other components | Pigment 2 | Parts by mass | 1.18 | 1.18 |
| | Antifoaming agent 1 | Parts by mass | 2.37 | 2.37 |
| | Heat-resistant stabilizer 1 | Parts by mass | 2.37 | 2.37 |
| | Heat-resistant stabilizer 2 | Parts by mass | 2.37 | 2.37 |
| | Reaction accelerator 1 | Parts by mass | - | 0.24 |
| Equivalent ratio [NCO/OH] | | - | - | - |
| Consistency (1/4 cone) (initial) | | - | 306 | 354 |
| Consistency (1/4 cone) (after 7 days) | | - | 321 | 350 |
| Consistency (1/4 cone) (after 40 days) | | - | 325 | 340 |

According to the results of Reference Example 1 and Reference Example 2, it can be seen that incorporation of the reaction accelerator leads to an increase in the consistency even if the polyisocyanate compound is not added. It is presumably because that the reaction accelerator reacts with the polymer-type surface treatment agent covering the surface of the filler to thereby allow the crosslinking reaction to progress.

## Claims

1. A thermally conductive urethane resin composition comprising a castor oil-based polyol, a polyisocyanate compound, and a filler, wherein

   an equivalent ratio [NCO/OH] of isocyanato groups of the polyisocyanate compound to hydroxyl groups of the castor oil-based polyol is from 0.8 to 1.6,
   the filler comprises a filler (A) having an average particle diameter of 0.03 to 10 μm, and
   the filler (A) has been surface-treated with a polymer-type surface treatment agent derived from an alkoxysilane and having a viscosity at 25°C of 10 to 500 mPa·s.

2. The thermally conductive urethane resin composition according to claim 1, wherein the polymer-type surface treatment agent is a compound represented by the following general formula (I):

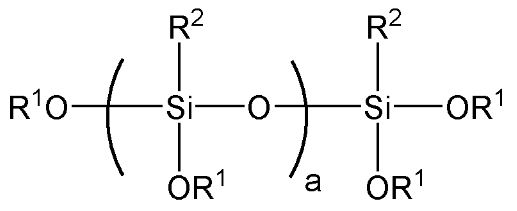

(I)

   wherein $R^1$ and $R^2$ are each independently an unsubstituted or substituted alkyl group, a plurality of $R^1$ and a plurality of $R^2$ are each optionally identical or different, and a is an integer of 1 to 30.

3. The thermally conductive urethane resin composition according to claim 1 or claim 2, wherein the filler further

comprises a filler (B) having an average particle diameter of more than 10 μm and 300 μm or less.

4. The thermally conductive urethane resin composition according to claim 3, further comprising a dispersant.

5. The thermally conductive urethane resin composition according to claim 3 or 4, wherein the filler (B) is aluminum nitride having a silicon-containing oxide coating on the surface thereof.

6. The thermally conductive urethane resin composition according to any one of claims 1 to 5, wherein a content of the filler (A) that has been surface-treated with the polymer-type surface treatment agent is from 1 to 1000 parts by mass based on 100 parts by mass in total of the castor oil-based polyol and the polyisocyanate compound.

7. The thermally conductive urethane resin composition according to any of claims 3 to 5, wherein a content of the filler (B) is from 300 to 3000 parts by mass based on 100 parts by mass in total of the castor oil-based polyol and the polyisocyanate compound.

8. The thermally conductive urethane resin composition according to any one of claims 1 to 7, wherein the polyisocyanate compound is at least one selected from the group consisting of polymethylene polyphenyl polyisocyanates, carbodiimide-modified diphenylmethane diisocyanates, castor oil-modified diphenylmethane diisocyanates, and allophanate-modified polyisocyanates.

9. The thermally conductive urethane resin composition according to claim 4, wherein the surface treatment agent does not interact with the dispersant.

10. The thermally conductive urethane resin composition according to any one of claims 1 to 9, having a consistency at 23°C of 290 to 400.

11. A cured product of the thermally conductive urethane resin composition according to any one of claims 1 to 10.

12. The cured product of the thermally conductive urethane resin composition according to claim 11, having a thermal conductivity of 3.0 W/m·K or more.

13. The cured product of the thermally conductive urethane resin composition according to claim 11 or 12, having a Shore 00 hardness measured in accordance with ASTM D2240 of 20 to 97.

14. A heat dissipation sheet comprising the cured product of the thermally conductive urethane resin composition according to any one of claims 11 to 13.

15. An electronic component comprising the cured product of the thermally conductive urethane resin composition according to any one of claims 11 to 13.

**TRANSLATION**

**INTERNATIONAL SEARCH REPORT**

International application No.
**PCT/JP2022/003250**

**A. CLASSIFICATION OF SUBJECT MATTER**

***C08G 18/36***(2006.01)i; ***C08G 18/08***(2006.01)i; ***C08K 9/06***(2006.01)i; ***C08L 75/04***(2006.01)i; ***H01L 23/373***(2006.01)i
FI: C08G18/36; C08G18/08 038; C08K9/06; C08L75/04; H01L23/36 M

According to International Patent Classification (IPC) or to both national classification and IPC

**B. FIELDS SEARCHED**

Minimum documentation searched (classification system followed by classification symbols)

C08G18/00-18/87; C08L1/00-101/16; C09D1/00-201/10; C09J1/00-201/10; C08K3/00-13/08; H01L23/34-23/473; C09K5/00-5/20

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

CAplus/REGISTRY (STN)

**C. DOCUMENTS CONSIDERED TO BE RELEVANT**

| Category* | Citation of document, with indication, where appropriate, of the relevant passages | Relevant to claim No. |
|---|---|---|
| A | CN 112322028 A (SHENZHEN AOCHUAN TECHNOLOGY CO., LTD.) 05 February 2021 (2021-02-05) | 1-15 |
| A | JP 2004-300300 A (BANDO CHEM IND LTD) 28 October 2004 (2004-10-28) | 1-15 |
| A | JP 2020-73623 A (SHOWA DENKO KK) 14 May 2020 (2020-05-14) | 1-15 |
| P, A | JP 2021-178922 A (SHOWA DENKO KK) 18 November 2021 (2021-11-18) | 1-15 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **05 April 2022** | **19 April 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**TRANSLATION**

**INTERNATIONAL SEARCH REPORT**
**Information on patent family members**

International application No.
**PCT/JP2022/003250**

| Patent document cited in search report | | | Publication date (day/month/year) | Patent family member(s) | Publication date (day/month/year) |
|---|---|---|---|---|---|
| CN | 112322028 | A | 05 February 2021 | (Family: none) | |
| JP | 2004-300300 | A | 28 October 2004 | (Family: none) | |
| JP | 2020-73623 | A | 14 May 2020 | (Family: none) | |
| JP | 2021-178922 | A | 18 November 2021 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2019001887 A
- JP 2015089909 A
- WO 2020077031 A
- CN 111607351 A